# EUROPEAN PATENT APPLICATION

(11) **EP 4 553 998 A1**
(43) Date of publication of application: **14.05.2025**
(21) Application number: 23845079.5
(22) Date of filing: 05.06.2023
(51) Int. Cl.: H01P 3/00

(54) **TRANSMISSION LINE ASSEMBLY, PRINTED CIRCUIT BOARD ASSEMBLY AND ELECTRONIC DEVICE**

(30) Priority: 29.07.2022 CN 202210906236
(71) Applicant: Huawei Technologies Co., Ltd., Shenzhen, Guangdong 518129 (CN)
(72) Inventor: LUO, Bing, Shenzhen, Guangdong 518129 (CN); QIN, Wenfei, Shenzhen, Guangdong 518129 (CN); SU, Guoyu, Shenzhen, Guangdong 518129 (CN)
(74) Representative: Pfenning, Meinig & Partner mbB
(86) International application number: PCT/CN2023/098328
(87) International publication number: WO 2024/021866

(57) **Abstract**

A transmission line assembly, a printed circuit board assembly, and an electronic device are provided, and relate to the field of printed circuit board technologies, to resolve a problem of a large signal loss of a signal line. The transmission line assembly includes a shielding cover and a signal line. The shielding cover is connected to a ground end. The shielding cover has an accommodation space. A first opening and a second opening are provided in the accommodation space. The signal line includes a first end and a second end that are disposed opposite to each other. The signal line penetrates the accommodation space, and there is a gap between the signal line and an inner side wall of the accommodation space. The first end passes through the first opening. The second end passes through the second opening. At least one of the first end and the second end of the signal line is configured to be connected to a signal end. The signal line is in an air dielectric, so that a signal loss is effectively reduced. The shielding cover wraps the signal line, so that radiation of the signal line can be prevented from overflowing and interfering with another transmission line. The shielding cover and the signal line are soldered to a printed circuit board by using a surface mount process. This can reduce process costs and process time.

## Description

This application claims priority to Chinese Patent Application No. 202210906236.6, filed with the China National Intellectual Property Administration on July 29, 2022 and entitled "TRANSMISSION LINE ASSEMBLY, PRINTED CIRCUIT BOARD ASSEMBLY, AND ELECTRONIC DEVICE", which is incorporated herein by reference in its entirety.

### TECHNICAL FIELD

Embodiments of this application relate to the field of printed circuit board technologies, and in particular, to a transmission line assembly, a printed circuit board assembly, and an electronic device.

### BACKGROUND

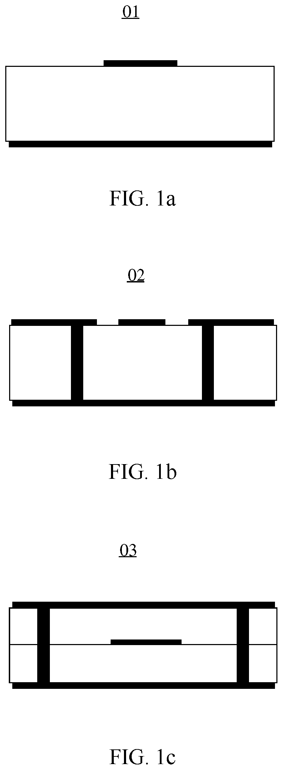

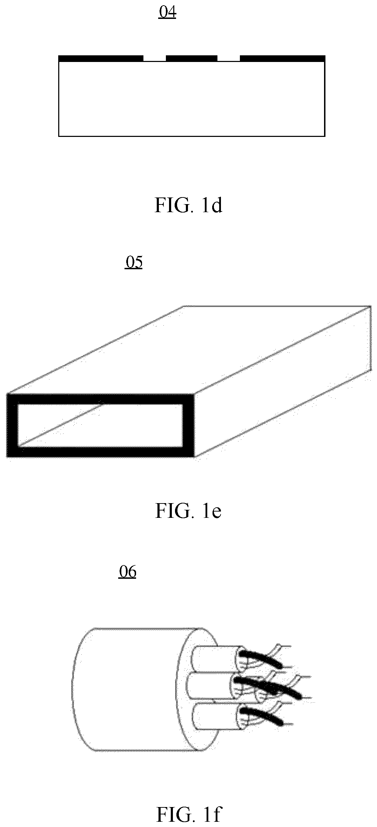

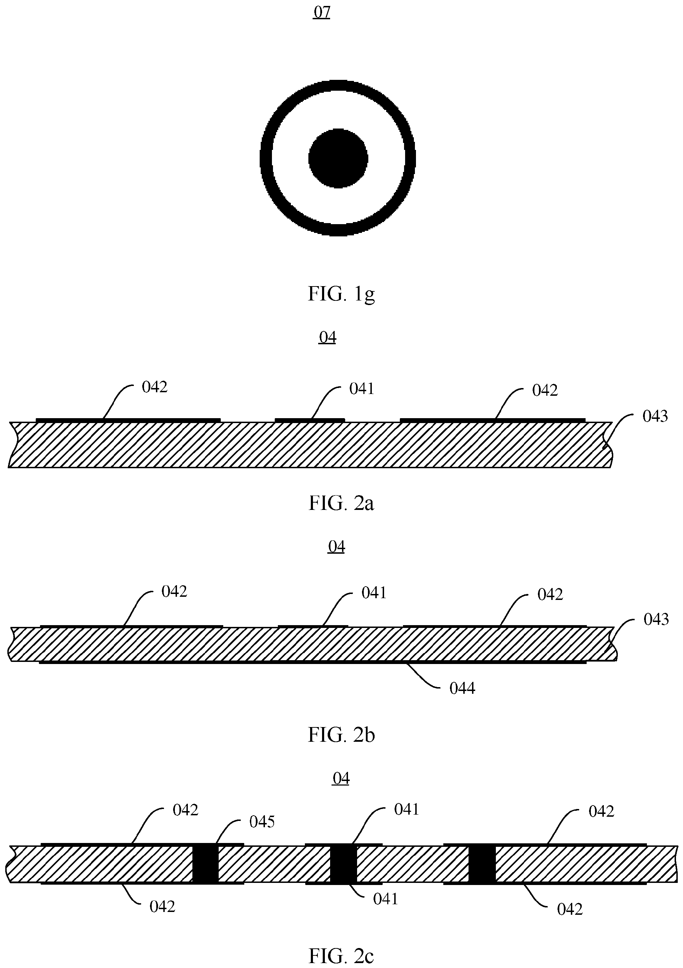

A transmission line is a most commonly used circuit structure in an electronic device, and is configured to transmit a radio frequency signal from one point to another point. As shown in FIG. 1a to FIG. 1g, commonly used transmission lines include: a microstrip line (microstrip line) 01, a grounded coplanar waveguide (grounded coplanar waveguide, GCPW) 02, a strip line (Strip line) 03, a coplanar waveguide (coplanar waveguide, CPW) 04, a rectangular waveguide 05, a twisted pair 06, a coaxial cable 07, and the like. The rectangular waveguide 05, the coaxial cable 07, and the twisted pair 06 have characteristics of a low loss, but cannot be directly integrated into a printed circuit board (printed circuit board, PCB) or inside a chip. The microstrip line 01, the strip line 03, the grounded coplanar waveguide 02, and the coplanar waveguide 04 have advantages of a high integration level, but have large losses.

To reduce a loss, a conventional technology mainly focuses on two aspects: a material and a structure.

For example, a microscopic molecular structure of a dielectric material is changed, to reduce a dielectric loss. However, material manufacturing costs are high, and derivative problems such as low structural strength, poor flame retardant effect, and a weak corrosion resistance capability may also occur.

The coplanar waveguide 04 is used as an example. FIG. 2a is a diagram of a structure of a single-layer coplanar waveguide 04. As shown in FIG. 2a, a signal line 041 and a ground line 042 are located on a same surface of a dielectric printed circuit board 043. An area of overlap between the signal line 041 and the ground line 042 is small, and impedance of the signal line 041 is high. In addition, due to skin effect, current distribution is concentrated at an edge of the signal line 041. A small current distribution area causes an increase in a loss.

FIG. 2b is a diagram of a structure of a single-layer coplanar waveguide 04 with a reference ground. As shown in FIG. 2b, a signal line 041 and a ground line 042 are disposed on a surface of a dielectric printed circuit board 043. The reference ground 044 is disposed on the other surface of the dielectric printed circuit board 043. This may enhance isolation between the signal line 041 and another adjacent transmission line, but a loss of the single-layer coplanar waveguide 04 with the reference ground is still large.

FIG. 2c is a diagram of a structure of a double-layer coplanar waveguide. As shown in FIG. 2c, a signal line 041 and a ground line 042 are distributed on each of two sides of a dielectric printed circuit board 043. Signal lines 041 on the two sides are connected through a metalized via 045. Ground lines 042 on the two sides are connected through a metalized via 045.

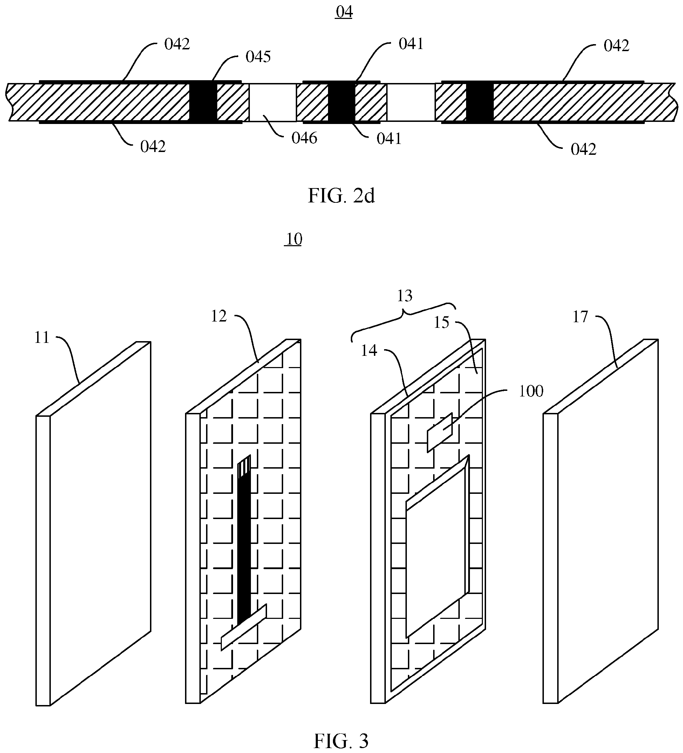

FIG. 2d is a diagram of a structure of a double-layer coplanar waveguide with a groove. A difference between FIG. 2d and FIG. 2c lies in that a groove 046 is provided on a dielectric printed circuit board 043, to reduce usage of a dielectric material.

In each of FIG. 2c and FIG. 2d, a groove is provided on a ground plane; consequently, damage is caused to integrity of the ground plane. As a result, a signal line 041 has poor sealing performance, and is prone to radiate to outside or interfere with another adjacent signal line.

Therefore, how to reduce a signal loss of a signal line is still a problem that needs to be resolved in a circuit structure.

### SUMMARY

Embodiments of this application provide a transmission line assembly, a printed circuit board assembly, and an electronic device, to resolve a problem of a large signal loss of a signal transmission line.

To achieve the foregoing objective, the following technical solutions are used in this application.

According to a first aspect, a transmission line assembly is provided, configured to be connected to a printed circuit board. A signal end and a ground end are disposed on a surface of the printed circuit board. The transmission line assembly includes a shielding cover and a signal line. The shielding cover is configured to be connected to the ground end. The shielding cover has an accommodation space. A first opening and a second opening are provided in the accommodation space. The signal line includes a first end and a second end that are disposed opposite to each other. The signal line penetrates the accommodation space, and there is a gap between the signal line and an inner side wall of the accommodation space. The first end passes through the first opening. The second end passes through the second opening. At least one of the first end and the second end is configured to be connected to the signal end. In this way, most of the signal line is in an air dielectric. In comparison with a case in which the signal line is in a dielectric layer, a signal loss can be effectively reduced in the air dielectric. In addition, the signal line penetrates the accommodation space of the shielding cover. The shielding cover can prevent radiation of the signal line from overflowing and interfering with another transmission line. Similarly, the shielding cover can also avoid interference to the signal line caused by another transmission line.

With reference to the first aspect, in some implementations, the transmission line assembly further includes an insulation member. The insulation member is disposed in the gap. An inner side wall of the insulation member abuts against the signal line. An outer side wall of the insulation member abuts against the inner side wall of the accommodation space. In this way, the insulation member may insulate the signal line and the shielding cover, to avoid an electrical connection between the signal line and the shielding cover.

With reference to the first aspect, in some implementations, the insulation member is of an open-loop structure. In this way, use of a material of the insulation member can be reduced, conversion of electromagnetic energy of the signal line can be reduced, and a loss can be reduced.

With reference to the first aspect, in some implementations, the insulation member is of a closed-loop structure. In this way, the insulation member can avoid the electrical connection between the signal line and the shielding cover.

With reference to the first aspect, in some implementations, the first opening is located at an end portion of the shielding cover. In this way, a corner may not be disposed at the first end of the signal line in the accommodation space, thereby reducing a volume of the shielding cover and increasing an integration level of the printed circuit board.

With reference to the first aspect, in some implementations, the second opening is located at an end portion of the shielding cover. In this way, a corner may not be disposed at the second end of the signal line in the accommodation space. This helps reduce a size of the shielding cover.

With reference to the first aspect, in some implementations, a window is further provided in the accommodation space. The window is located between two ends of the shielding cover. In this way, existence of the window can reduce a weight of the shielding cover, reduce material costs and process costs of the shielding cover, and effectively increase the integration level of the printed circuit board.

With reference to the first aspect, in some implementations, the window extends from an edge of the first opening to an edge of the second opening. In this way, manufacturing costs of the shielding cover are reduced.

With reference to the first aspect, in some implementations, a distance from a plane on which the window is located to the signal line is greater than a minimum distance from the signal line to the inner side wall of the accommodation space. In this way, a proportion of a capability of the signal line to radiate a signal to outside may be controlled to be less than one thousandth.

With reference to the first aspect, in some implementations, there are a plurality of signal lines, and there are a plurality of signal lines spaced from each other in one accommodation space. In this way, space can be fully utilized, and a volume of the printed circuit board can be reduced.

With reference to the first aspect, in some implementations, a cross section of the shielding cover includes a bending structure. The cross section is perpendicular to an extension direction of the signal line. The bending structure encloses a plurality of bending areas. At least one signal line penetrates one bending area. In this way, the bending area of the bending structure has a blocking function on a signal of the signal line, and mutual interference between adjacent signal lines is weakened.

With reference to the first aspect, in some implementations, the shielding cover includes a plurality of sub-covers. The plurality of sub-covers are spaced from each other along an extension path of the signal line. In this way, the shielding cover formed by the plurality of sub-covers in a distributed manner can reduce manufacturing costs. In addition, in an assembly process, a position and a direction of the sub-cover may be adjusted, so that the sub-cover can be applicable to more forms of extension paths of signal lines.

With reference to the first aspect, in some implementations, the signal line further includes a third end. The third end is located between the first end and the second end. A third opening is provided in the accommodation space. The third end passes through the third opening. At least one of the first end, the second end, and the third end is configured to be connected to the signal end. In this way, shielding may be provided for a signal line with a signal branch in a middle, for example, a power divider. In addition, the signal line is in the air dielectric, so that a signal loss of the signal line is reduced.

With reference to the first aspect, in some implementations, at least two of an end face of the first end, an end face of the second end, and an end face that is of the shielding cover and that is used to be connected to the ground end are coplanar. In this way, when the transmission line assembly and the printed circuit board are connected by using a surface mount process, simultaneously connecting more than two surfaces can reduce process costs and a process time.

According to a second aspect, a printed circuit board assembly is provided. The printed circuit board assembly includes: a printed circuit board and any transmission line assembly provided in the first aspect. A signal end and a ground end are disposed on a surface of the printed circuit board. The shielding cover is connected to the ground end, and at least one of the first end and the second end is connected to the signal end. A signal loss of the transmission line assembly is small. Therefore, a material selected for the printed circuit board may not be limited to a low-loss radio frequency plate material. This helps reduce costs.

With reference to the second aspect, in some implementations, both the first opening and the second opening face the printed circuit board. In this way, the printed circuit board can block the first opening and the second opening, so that radiation of a signal line is prevented from overflowing from the first opening and the second opening and interfering with another transmission line.

With reference to the second aspect, in some implementations, a window of the shielding cover faces the printed circuit board. In this way, the printed circuit board can block the window, so that the radiation of the signal line can be prevented from overflowing from the window and interfering with another transmission line.

With reference to the second aspect, in some implementations, a window of the shielding cover faces away from the printed circuit board. In this way, there is a low probability that the radiation in the signal line leaks from a gap between the shielding cover and the ground end, and impact of the radiation on an adjacent transmission line is small.

With reference to the second aspect, in some implementations, the shielding cover is soldered to the ground end by using a surface mount process. In this way, a technological process of the printed circuit board can be shortened, and manufacturing costs can be reduced.

With reference to the second aspect, in some implementations, the first end and/or the second end are/is soldered to a first signal end by using the surface mount process. In this way, a technological process of the printed circuit board can be shortened, and manufacturing costs can be reduced.

According to a third aspect, an electronic device is provided. The electronic device includes a housing and any printed circuit board assembly provided in the second aspect. The printed circuit board assembly is located in the housing. Because electrical performance of the printed circuit board assembly is improved, electrical performance of the electronic device is improved accordingly. A high integration level of the printed circuit board is conducive to lightness and thinness of the electronic device.

### BRIEF DESCRIPTION OF DRAWINGS

FIG. 1a is a diagram of a structure of a microstrip line;
FIG. 1b is a diagram of a structure of a grounded coplanar waveguide;
FIG. 1c is a diagram of a structure of a strip line;
FIG. 1d is a diagram of a structure of a coplanar waveguide;
FIG. 1e is a diagram of a structure of a rectangular waveguide;
FIG. 1f is a diagram of a structure of a twisted pair;
FIG. 1g is a diagram of a structure of a coaxial cable;
FIG. 2a is a diagram of a structure of a single-layer coplanar waveguide;
FIG. 2b is a diagram of a structure of a single-layer coplanar waveguide with a reference ground;
FIG. 2c is a diagram of a structure of a double-layer coplanar waveguide;
FIG. 2d is a diagram of a structure of a double-layer coplanar waveguide with a groove;
FIG. 3 is a diagram of a structure of an electronic device;
FIG. 4 is a diagram of electric field distribution of a microstrip line;
FIG. 5a is a diagram of a structure of a printed circuit board assembly according to an embodiment of this application;
FIG. 5b is a diagram of structures of a printed circuit board and a signal line according to an embodiment of this application;
FIG. 6a is a diagram of a structure of a transmission line assembly according to an embodiment of this application;
FIG. 6b is a cross-sectional view of a transmission line assembly according to an embodiment of this application;
FIG. 6c is another cross-sectional view of a transmission line assembly according to an embodiment of this application;
FIG. 6d is still another cross-sectional view of a transmission line assembly according to an embodiment of this application;
FIG. 7a is a diagram of structures of a first shielding cover and a signal line in Example 1;
FIG. 7b is a diagram of structures of a second shielding cover and a signal line in Example 1;
FIG. 7c is a diagram of structures of a third shielding cover and a signal line in Example 1;
FIG. 8a is a diagram of structures of a fourth shielding cover and a signal line in Example 1;
FIG. 8b is a diagram of structures of a fifth shielding cover and a signal line in Example 1;
FIG. 9 is a diagram of structures of a shielding cover and a plurality of signal lines in Example 1;
FIG. 10a is a diagram of structures of a sixth shielding cover and a signal line in Example 1;
FIG. 10b is a cross-sectional view of an embodiment of a sixth shielding cover in Example 1;
FIG. 10c is a cross-sectional view of another embodiment of a sixth shielding cover in Example 1;
FIG. 10d is a diagram of structures of a seventh shielding cover and a signal line in Example 1;
FIG. 10e is a cross-sectional view of an embodiment of a seventh shielding cover in Example 1;
FIG. 10f is a cross-sectional view of another embodiment of a seventh shielding cover in Example 1;
FIG. 10g is a cross-sectional view of still another embodiment of a seventh shielding cover in Example 1;
FIG. 10h is a diagram of a structure of yet another embodiment of a seventh shielding cover in Example 1;
FIG. 11 is a diagram of structures of a shielding cover and a signal line according to Example 2 of this application;
FIG. 12 is a diagram of structures of a shielding cover and a signal line according to Example 3 of this application;
FIG. 13a is a diagram of a structure of a connection between the shielding cover in FIG. 8b and a printed circuit board;
FIG. 13b is a diagram of a structure of another connection between the shielding cover in FIG. 8b and a printed circuit board;
FIG. 13c is a schematic cross-sectional view of a printed circuit board and a shielding cover whose window is not closed by the printed circuit board;
FIG. 13d is a diagram of a structure of still another connection between the shielding cover in FIG. 8b and a printed circuit board;
FIG. 13e is a diagram of a structure of a surface of the shielding cover in FIG. 7b;
FIG. 14a is a diagram of a structure of a connection between a shielding cover with a window and a printed circuit board; and
FIG. 14b is a diagram of a structure of another connection between a shielding cover with a window and a printed circuit board.

In the figures: 01: microstrip line; 02: grounded coplanar waveguide; 03: strip line; 04: coplanar waveguide; 041: signal line; 042: ground line; 043: dielectric printed circuit board; 044: reference ground; 045: metalized via; 046: groove; 05: rectangular waveguide; 06: twisted pair; 07: coaxial cable; 05: rectangular waveguide; 06: twisted pair; 07: coaxial cable; 10: electronic device; 11: cover; 12: display; 13: middle frame; 14: frame; 15: bearing plate; 17: rear housing; 100: printed circuit board assembly; 101: cavity; 110: printed circuit board; 111: first signal end; 112: second signal end; 113: ground end; 120: chip; 150: signal connector; 160: ground electrical connector; 200: transmission line assembly; 201: accommodation space; 202: first opening; 203: second opening; 204: window; 205: baffle plate; 206: third opening; 207: bending area; 208: bending structure; 210: shielding cover; 211: sub-cover; 212: electrical connector; 220: signal line; 221: first end; 222: second end; 223: third end; 230: insulation member.

### DESCRIPTION OF EMBODIMENTS

To make objectives, technical solutions, and advantages of this application clearer, the following further describes this application in detail with reference to accompanying drawings.

The terms such as "first" and "second" mentioned below are merely intended for a purpose of description, and shall not be understood as an indication or implication of relative importance or implicit indication of a quantity of indicated technical features. Therefore, a feature limited by "first", "second", or the like may explicitly or implicitly include one or more features. In the descriptions of this application, unless otherwise stated, "a plurality of" means two or more than two.

In addition, in this application, orientation terms such as "upper" and "lower" are defined relative to orientations of components schematically placed in the accompanying drawings. It should be understood that these orientation terms are relative concepts used for relative description and clarification, and may change correspondingly based on a change in an orientation in which the component is placed in the accompanying drawings.

Embodiments of this application provide an electronic device. The electronic device may be different types of user equipment or terminal devices, for example, a mobile phone (mobile phone), a tablet computer (pad), a personal digital assistant (personal digital assistant, PDA), a television, an intelligent wearable product (for example, a smartwatch or a smart band), a virtual reality (virtual reality, VR) terminal device, an augmented reality (augmented reality, AR) terminal device, a charging small household appliance (for example, a soybean milk machine or a robotic vacuum cleaner), an unmanned aerial vehicle, a radar, an aerospace device, and a vehicle-mounted device. A specific form of the electronic device is not specially limited in embodiments of this application.

For ease of description, the following uses an example in which the electronic device is a mobile phone for description. As shown in FIG. 3, an electronic device 10 mainly includes a cover 11, a display 12, a middle frame 13, and a rear housing 17. The rear housing 17 and the display 12 are respectively located on two sides of the middle frame 13, and the middle frame 13 and the display 12 are disposed in the rear housing 17. The cover 11 is disposed on a side that is of the display 12 and that is away from the middle frame 13. A display surface of the display 12 faces the cover 11.

The middle frame 13 includes a bearing plate 15 and a frame 14 around the bearing plate 15. Electronic components such as a printed circuit board (printed circuit board, PCB) assembly 100, a battery, and a camera in the electronic device 10 may be disposed on the bearing plate 15.

One of functions of the printed circuit board assembly 100 is to integrate the electronic components of the electronic device 10, for example, to implement interconnection between chips. A connection between the electronic components is mainly implemented by using a transmission line.

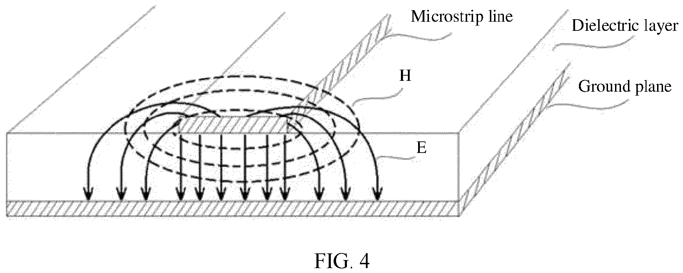

The foregoing transmission line is, for example, a microstrip line. FIG. 4 is a diagram of electric field distribution of the microstrip line. In FIG. 4, H is magnetic field strength, and E is electric field strength. It can be learned from FIG. 4 that, in a signal transmission process, most electric fields are distributed in a dielectric. Molecules of the dielectric generate vibration under an action of an alternating electric field, and a part of electromagnetic energy is converted into heat energy. As a result, signal energy at an output point of the transmission line is reduced, thereby causing a loss. In addition, a higher integration level of the printed circuit board indicates a larger loss.

Therefore, an embodiment of this application provides a printed circuit board, to reduce a loss of a transmission line.

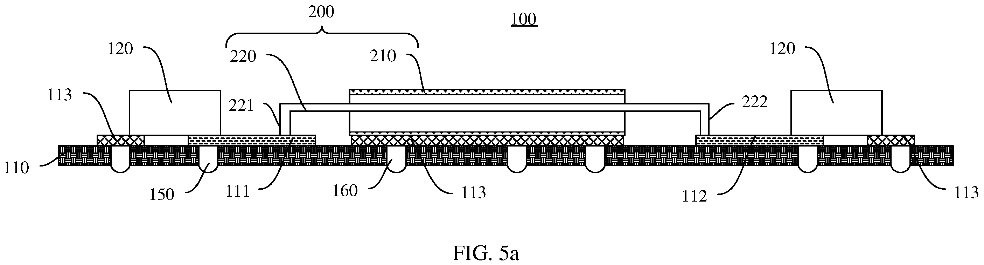

FIG. 5a is a diagram of a structure of the printed circuit board assembly 100 according to an embodiment of this application. Refer to FIG. 5a. The printed circuit board assembly 100 includes a printed circuit board 110, a chip 120, and a transmission line assembly 200. The chip 120 and the transmission line assembly 200 are located on a same surface of the printed circuit board 110.

It should be noted that, in another embodiment of this application, a structure at a position of the chip 120 in FIG. 5a may be another electric component, and is not limited to the chip 120. In this embodiment, the chip is used as an example for description.

At least one end of the transmission line assembly 200 is connected to a signal end on a surface of the printed circuit board 110. For example, two ends of the transmission line assembly 200 may both be connected to the signal end on the surface of the printed circuit board 110; or one end of the transmission line assembly 200 is connected to the signal end on the surface of the printed circuit board 110, and the other end is connected to a transmission line (for example, a cable) outside the printed circuit board 110.

Similarly, in an embodiment in which the transmission line assembly 200 has a plurality of branches, at least one end of the transmission line assembly 200 is connected to the signal end on the surface of the printed circuit board 110.

In this embodiment of this application, as shown in FIG. 5a, an example in which each end of the transmission line assembly 200 is connected to the signal end on the surface of the printed circuit board 110 is used for description.

A first signal end 111, a second signal end 112, and a ground end 113 are disposed on the surface of the printed circuit board 110.

The first signal end 111 and the second signal end 112 are respectively connected to signal pads of different chips 120, and a ground pad of the chip 120 is connected to the ground end 113.

A quantity of chips 120 is not limited in this embodiment of this application. For example, there may be two, three, four, or more chips 120, and the chips 120 may be disposed based on a function of the printed circuit board assembly 100.

The transmission line assembly 200 connects the first signal end 111 and the second signal end 112, so that the plurality of chips 120 are interconnected through the transmission line assembly 200.

Still refer to FIG. 5a. The printed circuit board assembly 100 further includes a plurality of signal connectors 150 and a plurality of ground electrical connectors 160. Both the signal connector 150 and the ground electrical connector 160 penetrate two opposite surfaces of the printed circuit board 110.

Both the first signal end 111 and the second signal end 112 are connected to the signal connector 150. An end that is of the signal connector 150 and that is away from the first signal end 111 may be connected to another component in the electronic device 10, for example, connected to the display 12.

The ground electrical connector 160 is connected to the ground end 113. One end that is of the ground electrical connector 160 and that is away from the ground end 113 is grounded.

The transmission line assembly 200 is an important factor that affects a signal loss of the chip 120. Therefore, an embodiment of this application provides a transmission line assembly 200 that can reduce a signal loss.

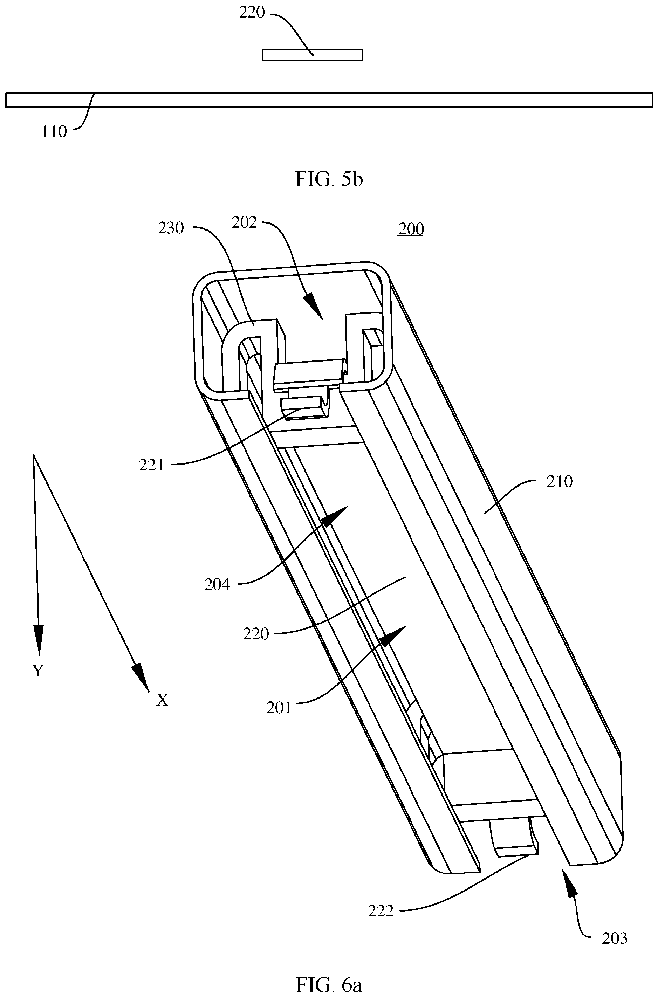

FIG. 6a is a diagram of a structure of the transmission line assembly 200 according to an embodiment of this application. Refer to FIG. 6a. The transmission line assembly 200 includes a shielding cover 210 and a signal line 220.

Refer to FIG. 5a and FIG. 6a together. The shielding cover 210 is connected to the ground end 113. In this way, the shielding cover 210 is connected to the ground electrical connector 160 through the ground end 113.

Two opposite ends of the signal line 220 are respectively connected to the first signal end 111 and the second signal end 112. Therefore, the signal pads of the different chips 120 are interconnected through the signal line 220.

The shielding cover 210 has an accommodation space 201. The signal line 220 penetrates the accommodation space 201, and there is a gap between the signal line 220 and an inner side wall of the shielding cover 210.

FIG. 5b is a diagram of structures of the printed circuit board 110 and the signal line 220 according to an embodiment of this application. There is a gap between the signal line 220 and the printed circuit board 110. Most of the signal line 220 is in the air.

In this way, most of the signal line 220 is in the air. In comparison with a case in which the signal line 220 is in a dielectric layer, a signal loss can be effectively reduced in the air. In addition, the signal line 220 is located in the accommodation space 201 of the shielding cover 210. The shielding cover 210 can prevent radiation of the signal line 220 from overflowing and interfering with another transmission line. Similarly, the shielding cover 210 can also avoid interference to the signal line 220 caused by another transmission line.

In FIG. 6a, the transmission line assembly 200 further includes an insulation member 230. The insulation member 230 is disposed in the gap between the signal line 220 and the shielding cover 210. An inner side wall of the insulation member 230 abuts against the signal line 220, and an outer side wall of the insulation member 230 abuts against the signal line 220. Abutting includes connection manners such as interconnection, and contact without connection. For example, the inner side wall of the insulation member 230 is in contact with but not connected to the signal line 220, or the inner side wall of the insulation member 230 is connected to the signal line 220. In this way, the insulation member 230 may insulate the signal line 220 and the shielding cover 210, to avoid a connection between the signal line 220 and the shielding cover 210.

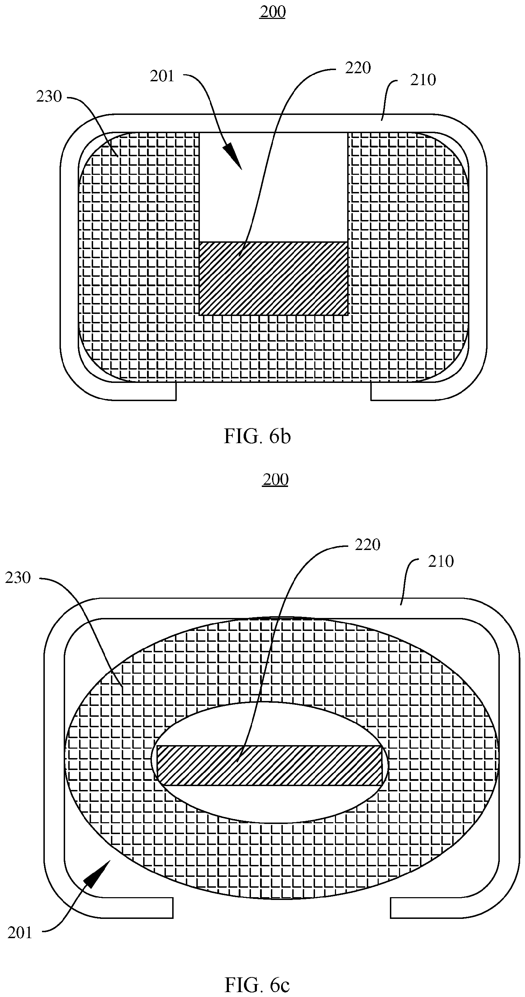

A structure of the insulation member 230 is not limited in this embodiment of this application. As shown in FIG. 6b, the insulation member 230 is of an open-loop structure. For example, on a cross section perpendicular to an extension direction of the signal line 220, the insulation member 230 of the open-loop structure surrounds the signal line 220, and has one or more notches. In this way, use of a material of the insulation member 230 can be reduced, conversion of electromagnetic energy of the signal line 220 can be reduced, and a loss can be reduced.

Alternatively, in another embodiment of this application, as shown in FIG. 6c, the insulation member 230 is of a closed-loop structure. For example, on a cross section perpendicular to an extension direction of the signal line 220, the insulation member 230 of the open-loop structure is connected end-to-end. For example, the insulation member 230 is an elliptic ring, and the insulation member 230 is clamped to the shielding cover 210. In this way, the insulation member 230 can avoid a short circuit in a circuit caused by the shielding cover 210 being connected to the signal line 220 due to reasons such as collapse.

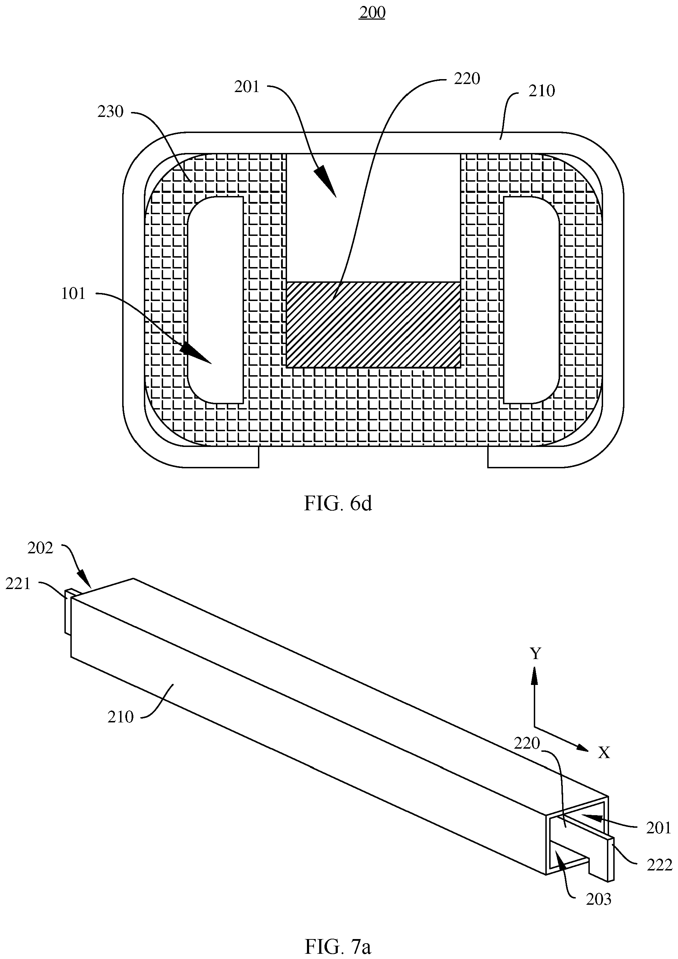

In some embodiments of this application, as shown in FIG. 6d, there is a cavity 101 inside the insulation member 230. The cavity 101 helps reduce a weight of the insulation member 230. In addition, in an embodiment in which the insulation member 230 is made of an elastic material, the cavity 101 may increase deformation space of the insulation member 230, so that abutting between the insulation member 230 and the signal line 220 is more stable.

In this embodiment of this application, a shape of the insulation member 230 is not limited to shapes shown in FIG. 6b, FIG. 6c, and FIG. 6d. A shape of an outer side of the insulation member 230 may be set based on a shape of an inner side wall of the accommodation space 201, so that the shape of the outer side of the insulation member 230 and the shape of the inner side wall of the accommodation space 201 are matched. A shape of an inner side of the insulation member 230 may be set based on a shape of the signal line 220, so that the shape of the inner side of the insulation member 230 and the shape of the signal line 220 are matched.

A quantity of insulation members 230 is not limited in this application. For example, there may be one, two, three, or more insulation members 230. In an embodiment in which there are a plurality of insulation members 230, the plurality of insulation members 230 are spaced from each other along the extension direction of the signal line 220.

If the quantity of insulation members 230 is small, production costs of the transmission line assembly 200 and a weight of the transmission line assembly 200 can be reduced. If the quantity of insulation members 230 is large, a risk of a short circuit in a circuit caused by collapse of the shielding cover 210 can be reduced.

In some embodiments, the insulation member 230 may not be disposed. For example, through support of a first end 221 and a second end 222 of the signal line 220, there may be the gap between the signal line 220 and the shielding cover 210, so that the signal line 220 and the shielding cover 210 are insulated.

Still refer to FIG. 6a. In an embodiment of this application, the signal line 220 includes the first end 221 and the second end 222, and the first end 221 and the second end 222 are disposed opposite to each other. The first end 221 is connected to the first signal end 111, and the second end 222 is connected to the second signal end 112.

An extension path of the signal line 220 is not limited in this embodiment of this application. The extension path of the signal line 220 is set based on a track of interconnection lines of the chips 120.

For example, the extension path of the signal line 220 is a curve or a plurality of straight lines with inflection points, or the extension path of the signal line 220 is a straight line, or the extension path of the signal line 220 has a plurality of branch lines.

An extension path of the shielding cover 210 is not limited in this embodiment of this application. The extension path of the shielding cover 210 is the same as the extension path of the signal line 220.

In this embodiment of this application, for ease of description, the extension direction of the shielding cover 210 is named as a first direction X, and a direction perpendicular to the extension direction of the shielding cover 210 is named as a second direction Y. The first direction X is parallel to a plane on which the printed circuit board 110 is located.

For an embodiment in which the extension path of the shielding cover 210 is a curve, an extension direction of a part of the shielding cover 210 is perpendicular to an extension path of the part.

A shape of the shielding cover 210 and a shape of the accommodation space 201 are not limited in this embodiment of this application. For example, the shape of the shielding cover 210 may be a cylindrical shape, a prism shape, or another irregular shape, and the accommodation space 201 may also be a cylindrical shape, a prism shape, or another irregular shape.

A material of the shielding cover 210 is not limited in this embodiment of this application. For example, the material of the shielding cover 210 may be, for example, sheet metal or a profile.

A molding process of the shielding cover 210 is not limited in this embodiment of this application. For example, the shielding cover 210 may be manufactured by using a die casting molding process or a drawing molding process.

In FIG. 6a, a first opening 202 and a second opening 203 are provided in the accommodation space 201 of the shielding cover 210. The first end 221 passes through the first opening 202, and the second end 222 passes through the second opening 203.

A position of the first opening 202 is not limited in this embodiment of this application. For example, the first opening 202 is located at an end portion of the shielding cover 210. In this way, an orientation of the first opening 202 is the first direction X. Alternatively, the first opening 202 is located between two ends of the shielding cover 210. In this way, an orientation of the first opening 202 is the second direction Y.

Similarly, a position of the second opening 203 is not limited in this embodiment of this application. For example, the second opening 203 is located at an end portion of the shielding cover 210, or the second opening 203 is located between the two ends of the shielding cover 210.

In some embodiments, the accommodation space 201 further has a window 204. The window 204 is located between the two ends of the shielding cover 210 in the first direction X. In this way, a weight of the shielding cover 210 can be reduced, a material can be reduced, and a weight of the printed circuit board assembly 100 can also be reduced.

A shape of the window 204 is not limited in this embodiment of this application. For example, in FIG. 6a, the window 204 is a rectangle. It may be understood that in another embodiment of this application, the shape of the window 204 may be waist-shaped, oval, circular, or the like.

Since the shape of the shielding cover 210 is related to the shape of the signal line 220, shielding covers 210 applicable to signal lines 220 of different shapes are described below as an example.

### Example 1

The signal line 220 is a straight line. In other words, the extension path of the signal line 220 is a straight line.

FIG. 7a is a diagram of structures of a first shielding cover 210 and the signal line 220 in Example 1. Refer to FIG. 7a. A first opening 202 and a second opening 203 are respectively located at two opposite ends of the shielding cover 210 in the first direction X. In this way, a corner may not be disposed in an accommodation space 201 of the signal line 220, thereby reducing a volume of the shielding cover 210 and increasing an integration level of the printed circuit board assembly 100.

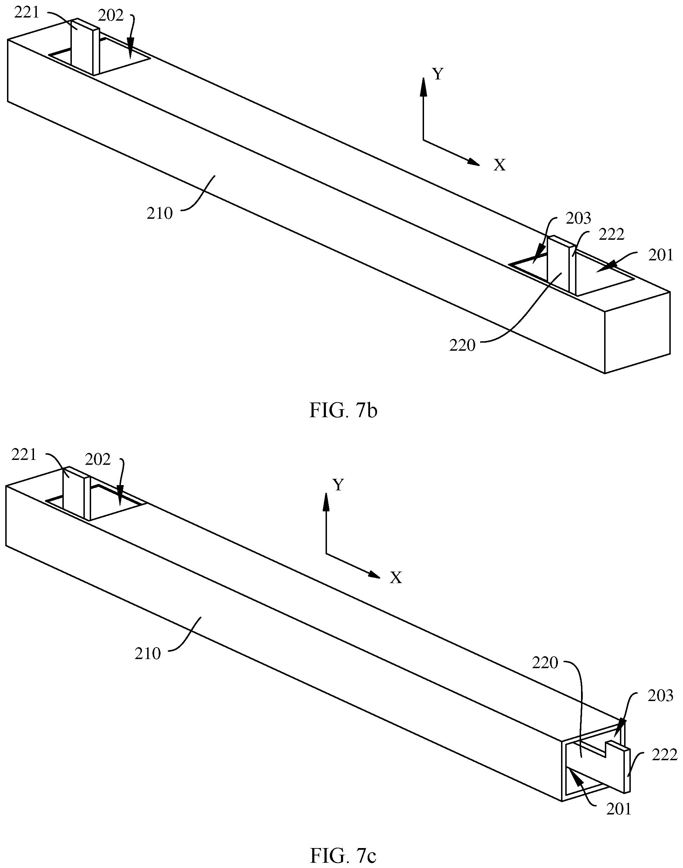

FIG. 7b is a diagram of structures of a second shielding cover 210 and the signal line 220 in Example 1. In FIG. 7b, a first opening 202 is provided between two ends of the shielding cover 210 in the first direction X, and a second opening 203 is provided between the two ends of the shielding cover 210 in the first direction X. In other words, both the first opening 202 and the second opening 203 are oriented toward the second direction Y.

In this way, even if some radiation of the signal line 220 overflows from the first opening 202 and the second opening 203, radiation toward the first direction X is small, and interference to another adjacent transmission line is small.

In some embodiments, to increase utilization space of the shielding cover 210 as much as possible, the first opening 202 may be as close as possible to one end of the shielding cover 210, and the second opening 203 may be as close as possible to the other end of the shielding cover 210. In this way, a length of the signal line 220 located in the accommodation space 201 in the first direction X is closer to a length of the shielding cover 210 in the first direction X, so that the shielding cover 210 can be fully used, a waste of the accommodation space 201 is reduced, and an integration level of the printed circuit board assembly 100 is increased.

In this embodiment of this application, opening directions of the first opening 202 and the second opening 203 are not limited to being the same.

For example, FIG. 7c is a diagram of structures of a third shielding cover 210 and the signal line 220 in Example 1. Refer to FIG. 7c. A second opening 203 is located at an end portion of the shielding cover 210 in the first direction X, and a first opening 202 is located between two ends of the shielding cover 210 in the first direction X. In other words, an opening direction of the second opening 203 is the first direction X, and an opening direction of the first opening 202 is the second direction Y.

Correspondingly, in some embodiments, an opening direction of the first opening 202 is the second direction Y, and an opening direction of the second opening 203 is the first direction X.

Therefore, the opening direction of the first opening 202 and the opening direction of the second opening 203 may be selected based on a position of the ground end 113, a position of the first signal end 111, and a position of the second signal end 112 on the printed circuit board assembly 100, and a length of the shielding cover 210 in the first direction X.

In FIG. 7a to FIG. 7c, the shielding cover 210 is disposed around the signal line 220. Therefore, the shielding cover 210 has a better radiation shielding capability for the signal line 220.

As described above, in some examples of this application, the window 204 is further provided in the shielding cover 210. A manner of providing the window 204 is not limited in this embodiment of this application.

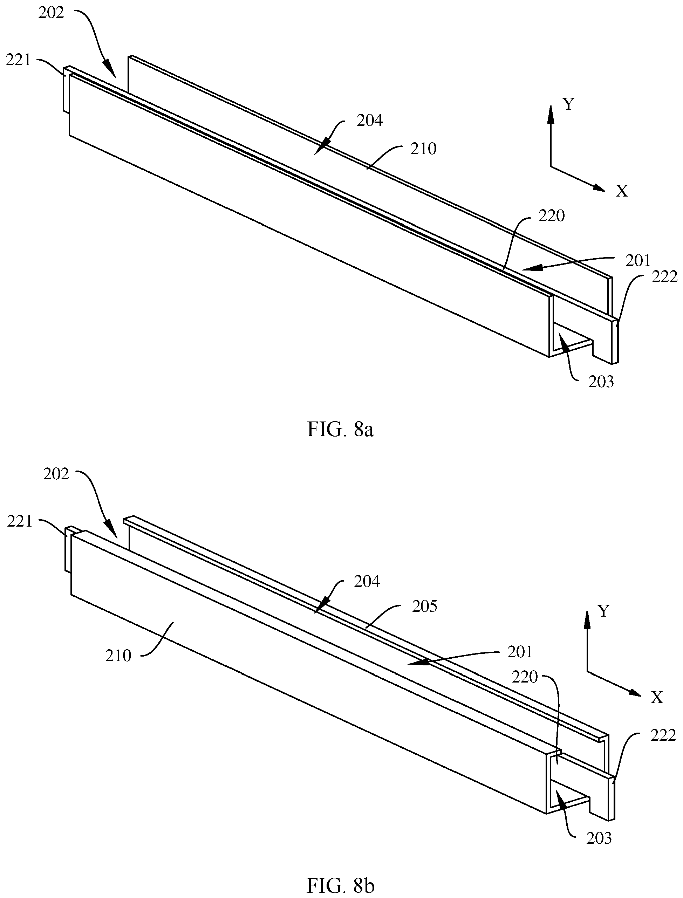

FIG. 8a is a diagram of structures of a fourth shielding cover 210 and the signal line 220 in Example 1. Refer to FIG. 8a and FIG. 7a. A difference between the fourth shielding cover 210 and FIG. 7a lies in that the fourth shielding cover 210 has a window 204.

A length of the window 204 in the first direction X is not limited in this embodiment of this application. For example, in FIG. 8a, the window 204 extends from an edge of a first opening 202 to an edge of a second opening 203.

In this way, the window 204 is provided, to reduce quality of the shielding cover 210, reduce a weight of the transmission line assembly 200, and effectively increase an integration level of the printed circuit board assembly 100. In addition, the shielding cover 210 shown in FIG. 8a may be formed by bending a thin plate, to reduce material costs and process costs of the shielding cover 210.

In this example, a width of the window 204 is not limited. For example, in FIG. 8a, the window 204 extends from one side of the shielding cover 210 to the opposite side. In this way, a projection of the shielding cover 210 on a plane in which the window 204 is located is located in an area of the window 204, so that a weight of the shielding cover 210 can be reduced.

FIG. 8b is a diagram of structures of a fifth shielding cover 210 and the signal line 220 in Example 1. A main difference between FIG. 8b and FIG. 7a lies in different positions of windows 204.

In FIG. 8b, a surface that is of the shielding cover 210 and on which the window 204 is provided has a baffle plate 205, the window 204 extends from a first opening 202 to a second opening 203, and the window 204 is coplanar with the baffle plate 205.

In FIG. 8b, the shielding cover 210 has two baffle plates 205, and the two baffle plates 205 are located on two opposite sides of the window 204. It may be understood that, in another embodiment, the shielding cover 210 may have only one baffle plate 205, and the baffle plate 205 is connected to one side of the shielding cover 210.

The window 204 is formed by surrounding the baffle plate 205, and a shape of the window 204 is related to the baffle plate 205. The shape of the window 204 is not limited in this embodiment of this application, and may be a straight line shape, a wave shape, a broken line shape, or the like.

In FIG. 8b, the baffle plate 205 may be configured to be connected to another component, for example, connected to a printed circuit board.

Similarly, the window 204 shown in FIG. 8a or FIG. 8b may also be provided in the shielding cover 210 shown in FIG. 7c. Details are not described herein again.

Opening directions of the first opening 202, the second opening 203, and the window 204 are not associated with each other, and the opening directions of the three may be independently selected.

Refer to FIG. 7a to FIG. 7c and FIG. 8a and FIG. 8b together. It can be seen that one signal line penetrates the shielding cover 210.

In a line design of the printed circuit board assembly 100, there may be a case in which a plurality of signal lines 220 have a same path and are parallel. To further reduce space occupied by the transmission line assembly 200 in an example in which the plurality of signal lines 220 are parallel, in some embodiments of this application, the plurality of signal lines 220 may penetrate into the shielding cover 210.

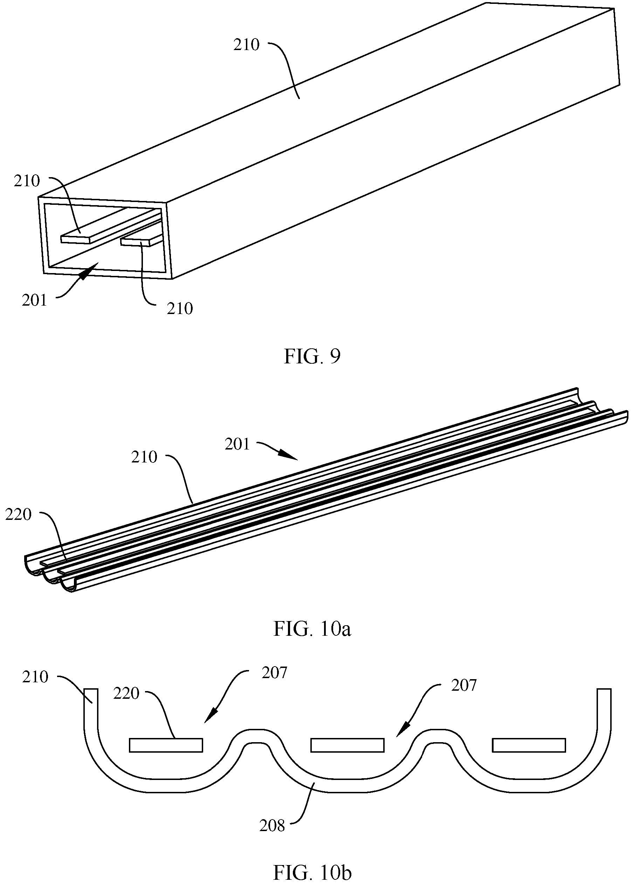

In some embodiments, as shown in FIG. 9, a size ratio of the shielding cover 210 to the signal line 220 is adjusted, so that the accommodation space 201 may allow two or more signal lines 220 to pass through, and the two signal lines 220 are disposed independently. In this way, the shielding cover 210 may provide a shielding function for the plurality of signal lines 220. This can fully utilize space, reduce a volume of the printed circuit board assembly 100, and make a contribution to lightness and thinness of the electronic device 10.

Similarly, for the shielding cover 210 in each of FIG. 7b to FIG. 7c and FIG. 8a and FIG. 8b, refer to a structure shown in FIG. 9. A plurality of signal lines 220 penetrate the shielding cover 210. Details are not described herein again.

In some embodiments, to avoid a short circuit caused by mutual contact between the signal lines 220, an insulation member 230 may be disposed between two signal lines 220. In other words, at least a part of the insulation member 230 is located between the two signal lines 220.

Further, to reduce mutual interference between the plurality of signal lines 220 in the shielding cover 210, in some embodiments, the accommodation space 201 in the shielding cover 210 is divided.

FIG. 10a is a diagram of structures of a sixth shielding cover 210 and the signal line 220 in Example 1. Refer to FIG. 10a. An accommodation space 201 is divided into a plurality of areas.

FIG. 10b is a diagram of a structure of the sixth shielding cover from another angle. Refer to FIG. 10b and FIG. 10a. A cross section of the shielding cover 210 includes a bending structure 208, the bending structure 208 encloses a plurality of bending areas 207, and at least one signal line 220 penetrates one bending area 207.

The foregoing cross section is perpendicular to the first direction X.

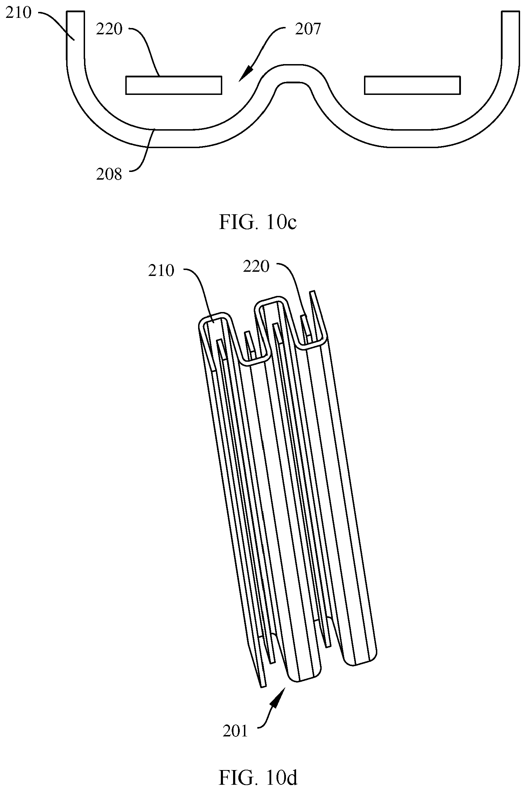

A quantity of bending areas 207 is not limited in this embodiment of this application. For example, in FIG. 10b, there are three bending areas 207, or in FIG. 10c, there are two bending areas 207.

In this embodiment of this application, a signal line 220 that penetrates into one bending area 207 is not limited. For example, one, two, or more signal lines 220 penetrate into one bending area 207.

Optionally, only a part of the bending areas 207 surrounded by the bending structure 208 may be penetrated by the signal line 220. In other words, in an embodiment in which there are a plurality of bending areas 207, the signal line 220 may penetrate each bending area 207, or the signal line 220 may penetrate only a part of the bending areas 207, and the signal line 220 does not penetrate the remaining bending areas 207.

In FIG. 10b, the bending area 207 of the bending structure 208 has a blocking function on a signal of the signal line 220. In this way, mutual interference between signal lines 220 located in the same accommodation space 201 is weakened. For example, two adjacent signal lines 220 are blocked by the bending area 207 in a direction opposite to the two adjacent signal lines 220.

In FIG. 10b, the bending structure 208 is a plurality of sequentially connected arc structures, and is approximately w-shaped. The bending area 207 is distributed on one side of the bending structure 208.

In FIG. 10b, two adjacent bending areas 207 communicate with each other.

A shape of the shielding cover 210 with a cross section including the bending structure 208 is not limited to the structure shown in FIG. 10b.

For example, FIG. 10d is a diagram of structures of a seventh shielding cover 210 and the signal line 220 in Example 1. Refer to FIG. 10d. An accommodation space 201 is divided into a plurality of areas.

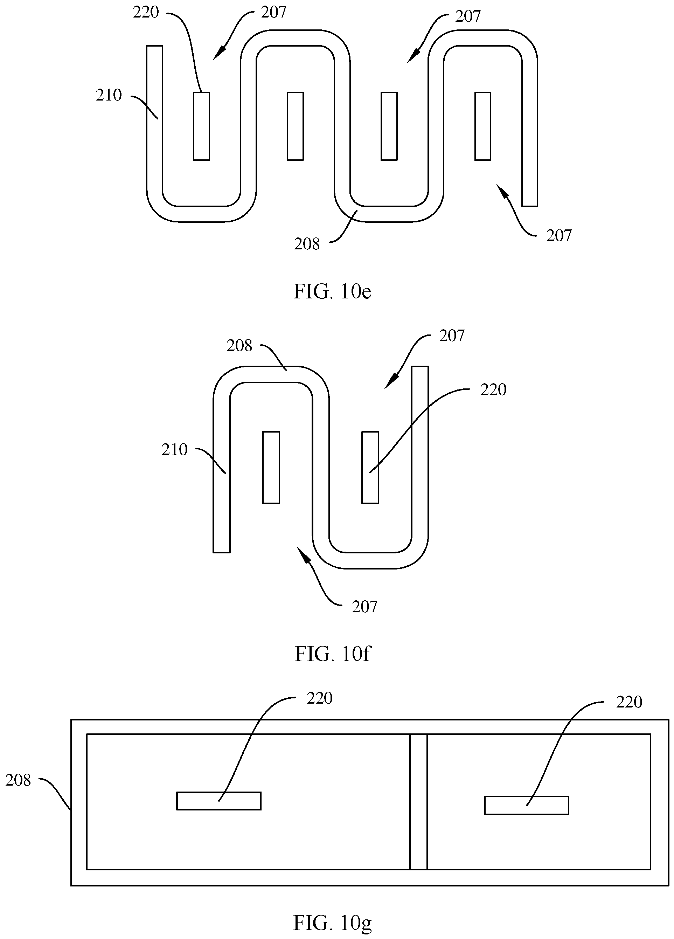

A main difference between the example in FIG. 10e and the example in FIG. 10b lies in bending structures 208. For the remaining structures, refer to related descriptions of the example in FIG. 10b. Details are not described herein again.

In FIG. 10e, bending areas 207 are distributed on two opposite sides of the bending structure 208.

In FIG. 10e, the bending structure 208 is a plurality of sequentially connected square structures, the bending structure 208 encloses a plurality of bending areas 207, and two adjacent bending areas 207 are independent of each other. In other words, in the second direction Y, the two adjacent bending areas 207 do not communicate.

In this way, in FIG. 10d, a bending structure 208 can better shield interference between signal lines 220 located in different bending areas 207, to reduce interference between signal lines 220.

Similarly, a quantity of bending areas 207 is not limited in this embodiment of this application. For example, in FIG. 10e, there are four bending areas 207, or in FIG. 10f, there are two bending areas 207.

Refer to FIG. 10a to FIG. 10d together. It may be understood that, in another embodiment of this application, the bending structure 208 is not limited to shapes shown in FIG. 10c and FIG. 10d, for example, may be in a "1x2 grid ( 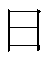 )" shape, a "1x4 grid ( 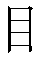 )" shape, a "2x2 grid ( 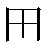 )" shape, or the like.

In some embodiments, the shielding cover 210 may further include a housing disposed around an outer periphery of the bending structure 208. In other words, the cross section of the shielding cover 210 may include only the bending structure 208, or the cross section of the shielding cover 210 may further include the housing disposed around the outer periphery of the bending structure 208, and the like.

For example, the shielding cover 210 may further include a bending structure 208 shown in FIG. 10g. In this way, shielding effect of the shielding cover 210 is better.

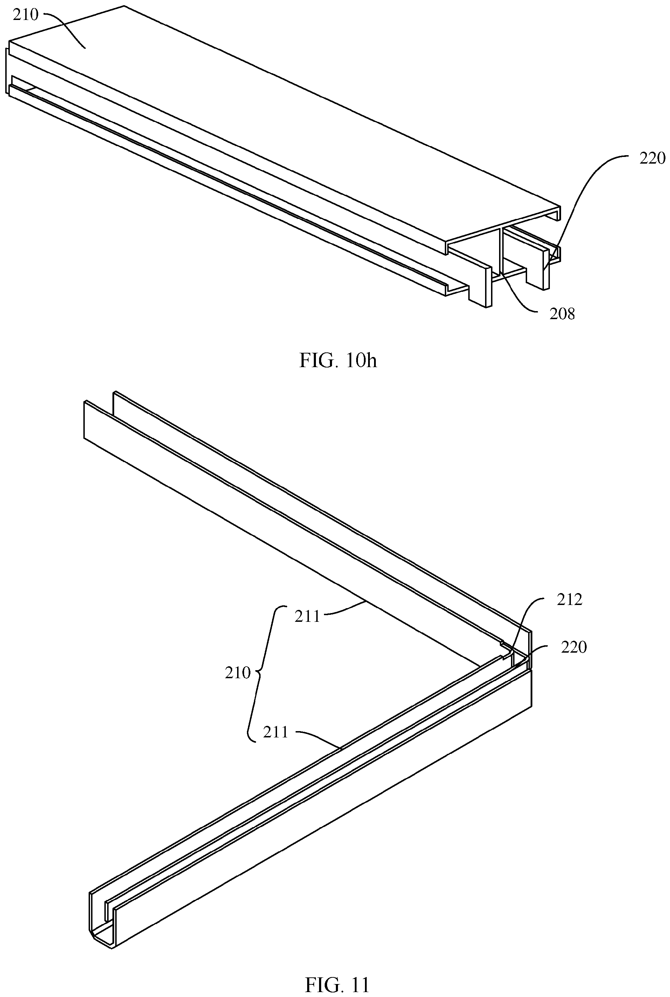

For example, the shielding cover 210 may further include a bending structure 208 shown in FIG. 10h. In this way, a weight of the shielding cover 210 is small, and the bending structure 208 can reduce mutual interference between signal lines 220 in the shielding cover 210.

In Example 1, the extension path of the shielding cover 210 is the straight line. Because a surface area of the printed circuit board 110 is limited, in some embodiments, the extension path of the signal line 220 may have a corner, a bend, and the like. In this way, the extension path of the shielding cover 210 may be a curve, a straight line with a plurality of inflection points, or the like.

Therefore, to reduce manufacturing costs of the shielding cover 210 whose extension path is the curve or the straight line with the plurality of inflection points, embodiments of this application further provide a shielding cover 210 shown in Example 2.

### Example 2

The signal line 220 is a broken line or a curve.

FIG. 11 is a diagram of structures of a shielding cover 210 and the signal line 220 according to Example 2 of this application. Refer to FIG. 11. The shielding cover 210 includes two sub-covers 211. The two sub-covers 211 are connected to each other. The two sub-covers 211 are spaced from each other along an extension path of the signal line 220.

Each sub-cover 211 has an opening for the signal line 220 to pass through.

A shape of the sub-cover 211 is not limited in this embodiment of this application. For the shape of the sub-cover 211, refer to the shape of the shielding cover 210 in Example 1. Details are not described herein again.

A length of the sub-cover 211 is not limited in this embodiment of this application. The length of the sub-cover 211 is related to a distance between two adjacent inflection points of the signal line 220, and may be set based on the distance.

A quantity of sub-covers 211 is not limited in this embodiment of this application, and may be set based on a quantity of inflection points of the signal line 220.

A connection manner between the sub-covers 211 is not limited in this embodiment of this application. For example, the sub-covers 211 may be connected through an electrical connector 212. The electrical connector 212 has a function of connecting two adjacent sub-covers 211. In addition, the electrical connector 212 also has a function of reducing signal overflow at an inflection point position of the signal line 220.

A structure of the electrical connector 212 is not limited in this application. For example, the electrical connector 212 may be a copper foil or the like.

It may be understood that, in another embodiment of this application, the electrical connector 212 may not be disposed. For example, two adjacent sub-covers 211 are not connected and are independent of each other.

Therefore, in an embodiment in which the extension path of the signal line 220 is the curve or the straight line with the plurality of inflection points, in comparison with an integrated shielding cover 210, the shielding cover 210 formed by the plurality of sub-covers 211 in a distributed manner may reduce manufacturing costs. In addition, in an assembly process, a position and a direction of the sub-cover 211 may be adjusted, so that the sub-cover 211 can be applicable to more forms of extension paths of signal lines 220.

In Example 1 and Example 2, the signal line 220 has two branches, namely, a first end 221 and a second end 222. In some application scenarios, a quantity of branches of the signal line 220 is not limited to two, that is, a transmission end of the signal line 220 is not limited to two ends of the signal line 220. For example, a power divider needs to lead out a signal distribution branch in a middle of the signal line 220.

Therefore, Example 3 of this application provides a shielding cover 210, and the shielding cover 210 may be applicable to a signal line 220 with a plurality of distribution branches.

### Example 3

A branch is further provided between a first end 221 and a second end 222 of the signal line 220, for example, a third end is further provided.

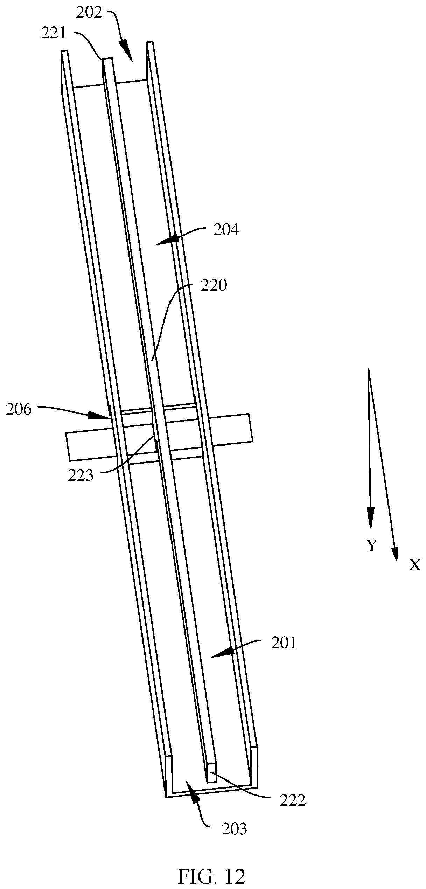

FIG. 12 is a diagram of structures of a shielding cover 210 and the signal line 220 according to Example 3 of this application. Refer to FIG. 12. The signal line 220 further includes the third end 223, and the third end 223 is located outside a third opening 206. A third opening 206 is further provided in an accommodation space 201 of the shielding cover 210.

The third end 223 of the signal line 220 is located between the first end 221 and the second end 222. The third end 223 of the signal line 220 is connected to a third signal end of the printed circuit board 110.

In this way, the transmission line assembly 200 may provide excellent shielding for the signal line 220 with three branches, and may also reduce a signal loss of the signal line 220.

For another structure of the shielding cover 210 in Example 3, refer to Example 1. Details are not described herein again.

Relative positions between the third end 223 and the signal line 220 are not limited in this embodiment of this application, and may be distributed based on a design of the signal line 220. For example, the third end 223 is located in a middle of the signal line 220.

A position of the third opening 206 is not limited in this embodiment of this application. For example, the third opening 206 is located between two ends of the shielding cover 210 in the first direction X.

For example, in FIG. 12, the third opening 206 is oriented toward the second direction Y. Alternatively, in some embodiments of this application, an opening direction of the third opening 206 may be the first direction X. For example, an opening direction of the first opening 202 or the second opening 203 is the second direction Y. In this way, the opening direction of the third opening 206 may be the first direction X.

Still refer to FIG. 5a. The transmission line assembly 200 is located on the surface of the printed circuit board 110, and the shielding cover 210 is connected to the ground end 113 on the surface of the printed circuit board 110. The signal line 220 is connected to the signal end on the surface of the printed circuit board 110.

A connection manner between the shielding cover 210 and the printed circuit board 110 is not limited in this embodiment of this application. For example, an outer surface that is of the shielding cover 210 and that is away from the accommodation space 201 is connected to the printed circuit board 110. In this way, a same shielding cover 210 may be connected to the printed circuit board 110 in a plurality of manners.

Still refer to FIG. 8b. The following uses a structure of a connection between the shielding cover 210 in FIG. 8b and the printed circuit board 110 as an example for description.

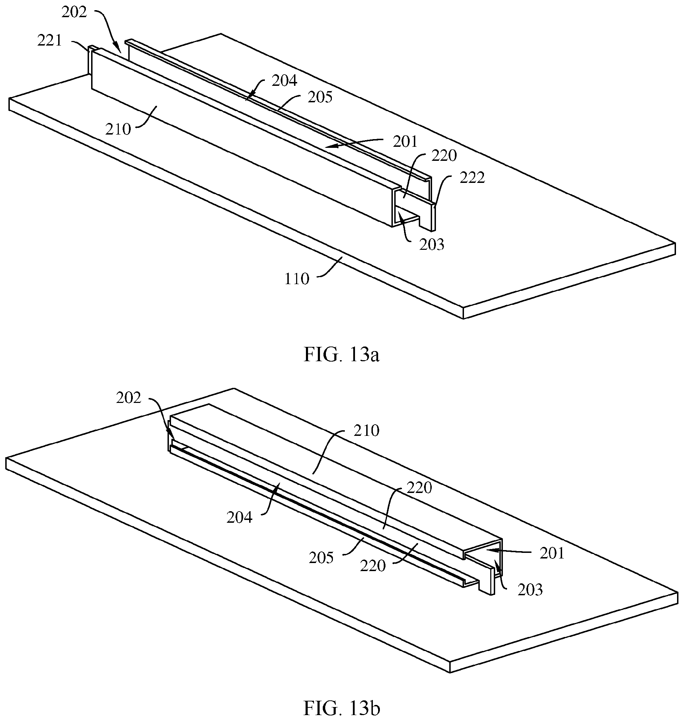

FIG. 13a is a diagram of a structure of a connection between the shielding cover 210 in FIG. 8b and the printed circuit board 110. Refer to FIG. 13a. A surface that is of the shielding cover 210 and that is away from the window 204 is connected to the printed circuit board 110. In other words, the window 204 is located on the surface that is of the shielding cover 210 and that is far away from the printed circuit board 110. In this way, the shielding cover 210 has a large contact area with the printed circuit board 110, there are many connecting parts between the shielding cover 210 and the printed circuit board 110 for selection, and an adjustable margin is large. This helps reduce assembly costs of the shielding cover 210 and the printed circuit board 110. It is assumed that radiation of the signal line 220 overflows from the window 204. In this way, the overflowed radiation has small impact on an adjacent signal line 220 and the signal end on the surface of the printed circuit board 110.

FIG. 13b is a diagram of a structure of another connection between the shielding cover 210 in FIG. 8b and the printed circuit board 110. Refer to FIG. 13b. A surface that is of the shielding cover 210 and that is adjacent to the window 204 is connected to the printed circuit board 110, and the window 204 faces away from the printed circuit board 110. The surface on which the window 204 is located is adjacent to the surface on which the shielding cover 210 is connected to the printed circuit board 110. Similarly, the shielding cover 210 has a large contact area with the printed circuit board 110, and an adjustable margin is large in an assembly process. In addition, because the window 204 faces away from the printed circuit board 110, even if there is a gap between the shielding cover 210 and the ground end 113, because the signal line 220 is blocked by the shielding cover 210 from the gap, there is a low probability that radiation emitted by the signal line 220 passes through the gap. Therefore, existence of the gap has small impact on radiation of the signal line 220 that interferes with other transmission lines.

In FIG. 12a and FIG. 13b, the window 204 is not closed by the printed circuit board 110. In some embodiments, a position relationship between the shielding cover 210 and the signal line 220 may be set, to reduce overflow of radiation in the signal line 220 from the window 204, and reduce interference of the signal line 220 to a transmission line outside the accommodation space 201.

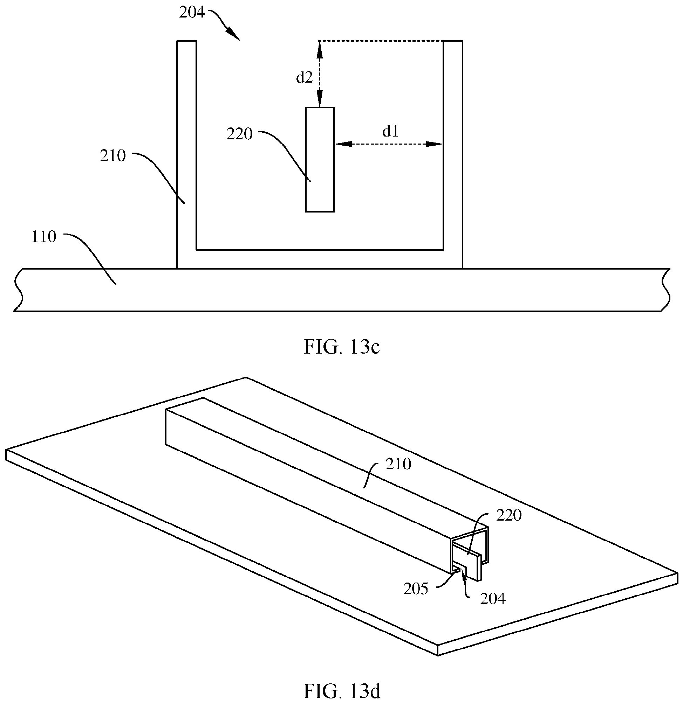

FIG. 13c is a schematic cross-sectional view of the printed circuit board 110 and a shielding cover 210 whose window 204 is not closed by the printed circuit board 110. In FIG. 13c, a minimum distance between the shielding cover 210 and the signal line 220 is d1, and a distance between a plane on which the window 204 is located and the signal line 220 is d2. In an embodiment in which d2 is greater than or equal to d1, a proportion of radiation overflowed from the signal line 220 to outside of the shielding cover 210 is less than one thousandth. In this way, even if the window 204 is not closed by the printed circuit board 110, interference of the signal line 220 to a transmission line outside an accommodation space 201 is limited, and an interference control requirement of most industrial electronic products and consumer electronic products can be met.

FIG. 13d is a diagram of a structure of still another connection between the shielding cover 210 in FIG. 8b and the printed circuit board 110. Refer to FIG. 13d. A surface of the baffle plate 205 of the shielding cover 210 is connected to the printed circuit board 110. In other words, the window 204 of the shielding cover 210 faces the printed circuit board 110. In this way, the printed circuit board 110 may block the window 204, so that radiation of the signal line 220 is prevented from overflowing from the window 204 and interfering with an adjacent transmission line.

Similarly, a structure of a connection between the shielding cover 210 and the printed circuit board 110 in another example is not limited in this embodiment of this application.

For example, after the shielding cover 210 in FIG. 7b is connected to the printed circuit board 110, both the first opening 202 and the second opening 203 may face away from the printed circuit board 110. In this way, a surface area of the shielding cover 210 connected to the printed circuit board 110 is large, and there are many parts for selection. Similarly, a plane on which the first opening 202 and the second opening 203 are located is adjacent to a surface that is of the shielding cover 210 and that is connected to the printed circuit board 110. Details are not described herein again.

Alternatively, after the shielding cover 210 in FIG. 7b is connected to the printed circuit board 110, both the first opening 202 and the second opening 203 may face the printed circuit board 110. In this way, both the first opening 202 and the second opening 203 are closed by the printed circuit board 110, so that overflow of radiation of the signal line 220 from the first opening 202 and the second opening 203 can be reduced.

A structure of a connection between the shielding cover 210 and the printed circuit board 110 in another example is similar. Details are not described herein again.

A connection manner between the shielding cover 210 and the printed circuit board 110 and a connection manner between the signal line 220 and the printed circuit board 110 are not limited in this embodiment of this application. For example, the shielding cover 210 is soldered to the printed circuit board 110 by using a surface mount process. The signal line 220 is soldered to the printed circuit board 110 by using the surface mount process.

The surface mount process soldering has a full name of a surface mount technology, and is a circuit mounting technology in which a pin-free or short-leaded surface mount component (SMC) is mounted on a surface of a printed circuit board or a surface of another substrate, and is soldered and assembled through reflow soldering, dip soldering, or another method.

It may be understood that, the connection manner between the shielding cover 210 and the printed circuit board 110 is not limited to soldering by using a surface mount process, for example, direct soldering by using a pin or the like.

For example, to reduce costs of the surface mount process, optionally, at least two surfaces of an end face of the first end 221 of the signal line 220, an end face of the second end 222 of the signal line 220, and an end face on which the shielding cover 210 is connected to the printed circuit board 110 are coplanar.

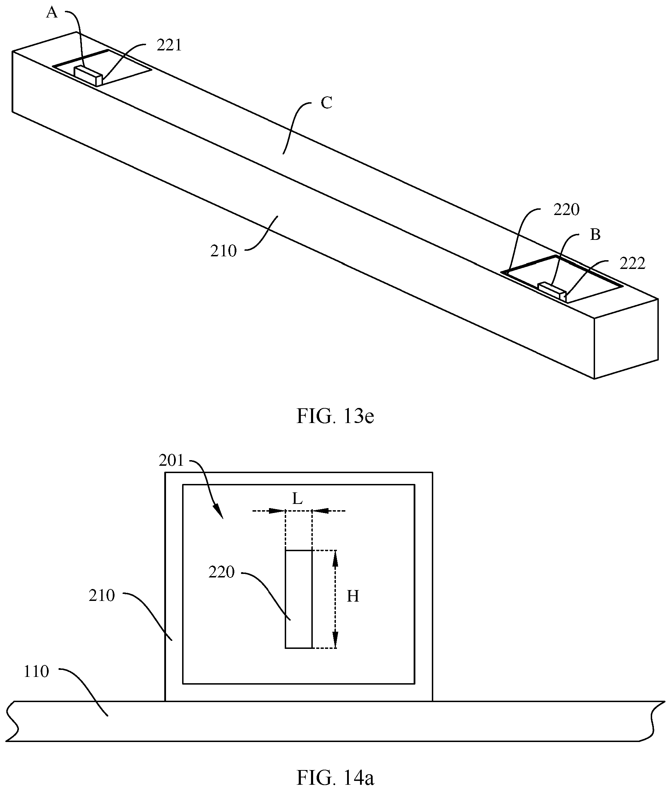

As shown in FIG. 13e, the shielding cover 210 in FIG. 7b is used as an example. At least two surfaces of a surface A of the first end 221 of the signal line 220, a surface B of the second end 222 of the signal line 220, and a surface C of the shielding cover 210 are coplanar. In other words, the surface A and the surface B are coplanar, or the surface A and the surface C are coplanar, or the surface B and the surface C are coplanar, or the surface A, the surface B, and the surface C are coplanar.

In this way, in a process of the surface mount process, more than two surfaces can be simultaneously attached, to shorten a connection time and reduce connection costs. In an embodiment in which two surfaces are attached at a time in a surface mount process, the remaining one surface may be soldered.

A size and a shape of the surface C are not limited in this embodiment of this application. For example, in FIG. 13e, an entire surface of the shielding cover 210 is configured to be connected to the printed circuit board 110. In another embodiment, the surface C may occupy only a part of a surface that is of the shielding cover 210 and that faces the printed circuit board 110. In addition, the surface C may be a continuous surface, or may be a plurality of discontinuous surfaces, and may be disposed based on a shape of the shielding cover 210.

In an embodiment in which the at least two surfaces of the surface A, the surface B, and the surface C are coplanar, the coplanar surfaces may be formed when the transmission line assembly 200 is manufactured, or may be formed before the transmission line assembly 200 is connected to the printed circuit board 110. In other words, in an embodiment of soldering by using a surface mount process, after the transmission line assembly 200 is manufactured, the transmission line assembly 200 meets a condition that the at least two surfaces of the surface A, the surface B, and the surface C are coplanar. Alternatively, if the transmission line assembly 200 does not meet a condition that the at least two surfaces are coplanar, before the transmission line assembly 200 is connected to the printed circuit board 110, the transmission line assembly 200 may be processed twice, so that the transmission line assembly 200 meets the foregoing condition.

A relative position relationship between the signal line 220 and the printed circuit board 110 is not limited in this embodiment of this application.

For example, in an embodiment in which a cross section of the signal line 220 is a flat structure, for example, in an embodiment in which a width of the cross section of the signal line 220 is greater than a height of the cross section, a width direction of the signal line 220 may be parallel to the surface of the printed circuit board 110, or a height direction of the signal line 220 may be parallel to the surface of the printed circuit board 110.

As shown in FIG. 14a, a size of the signal line 220 in the width direction is L, and a size of the signal line 220 in the height direction is H. The width L of the signal line 220 is less than the height H. After the shielding cover 210 is connected to the printed circuit board 110, a size of the printed circuit board assembly 100 in the width direction of the signal line 220 may be reduced.

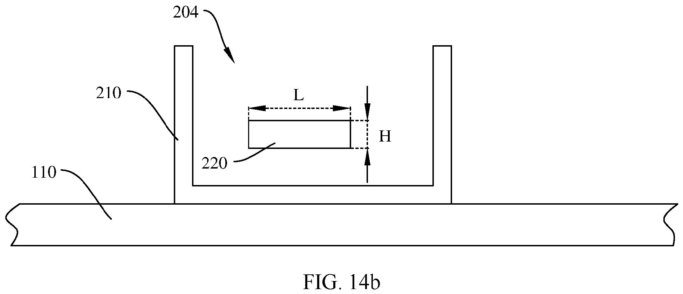

Similarly, as shown in FIG. 14b, a width L of the signal line 220 is greater than a height H. In this way, a size of the printed circuit board assembly 100 in the height direction of the signal line 220 can be reduced.

FIG. 14a and FIG. 14b are merely examples of the shielding cover 210. It may be understood that shielding covers 210 of other structures in Example 1 are similar. Details are not described herein again.

The signal loss of the transmission line assembly 200 is small, and in some embodiments, a loss of the transmission line assembly 200 per unit length is equivalent to that of a coaxial cable, and is about 50% of that of a common microstrip line. Therefore, a material selected for the printed circuit board assembly 100 may not be limited to a low-loss radio frequency plate material. This helps reduce costs. In addition, by using a structural design of the shielding cover 210, for example, the foregoing window 204 and the bending structure 208, the weight of the printed circuit board assembly 100 may be reduced. This helps increase an integration level. Further, in an embodiment in which the transmission line assembly 200 is soldered by using the surface mount process to be connected to the printed circuit board 110, a technological process of the printed circuit board assembly 100 is greatly shortened, integration is satisfied, and manufacturing costs are also reduced.

Similarly, because electrical performance of the printed circuit board assembly 100 is improved, electrical performance of the electronic device 10 is improved accordingly. A high integration level of the printed circuit board assembly 100 is conducive to lightness and thinness of the electronic device 10. Similarly, costs of the electronic device 10 may also be reduced due to reduction of costs of the printed circuit board assembly 100.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A transmission line assembly, configured to be connected to a printed circuit board, wherein a signal end and a ground end are disposed on a surface of the printed circuit board, and the transmission line assembly comprises:
a shielding cover, wherein the shielding cover is configured to be connected to the ground end, the shielding cover has an accommodation space, and a first opening and a second opening are provided in the accommodation space; and
a signal line, wherein the signal line comprises a first end and a second end that are disposed opposite to each other, the signal line penetrates the accommodation space, there is a gap between the signal line and an inner side wall of the accommodation space, the first end passes through the first opening, the second end passes through the second opening, and at least one of the first end and the second end is configured to be connected to the signal end.

2. The transmission line assembly according to claim 1, wherein the transmission line assembly further comprises an insulation member, the insulation member is disposed in the gap, an inner side wall of the insulation member abuts against the signal line, and an outer side wall of the insulation member abuts against the inner side wall of the accommodation space.

3. The transmission line assembly according to claim 2, wherein the insulation member is of an open-loop structure.

4. The transmission line assembly according to claim 2, wherein the insulation member is of a closed-loop structure.

5. The transmission line assembly according to any one of claims 1 to 4, wherein the first opening and the second opening are respectively located at two opposite end portions of the shielding cover.

6. The transmission line assembly according to any one of claims 1 to 5, wherein at least one of the second opening and the first opening is located between two ends of the shielding cover.

7. The transmission line assembly according to any one of claims 1 to 6, wherein a window is further provided in the accommodation space, and the window is located between the two ends of the shielding cover.

8. The transmission line assembly according to claim 7, wherein the window extends from an edge of the first opening to an edge of the second opening.

9. The transmission line assembly according to claim 7, wherein a distance from a plane on which the window is located to the signal line is greater than a minimum distance from the signal line to the inner side wall of the accommodation space.

10. The transmission line assembly according to any one of claims 1 to 9, wherein there are a plurality of signal lines, and there are a plurality of signal lines spaced from each other in one accommodation space.

11. The transmission line assembly according to any one of claims 1 to 10, wherein a cross section of the shielding cover comprises a bending structure, the cross section is perpendicular to an extension direction of the signal line, the bending structure encloses a plurality of bending areas, and at least one signal line penetrates one bending area.

12. The transmission line assembly according to any one of claims 1 to 11, wherein the shielding cover comprises a plurality of sub-covers, and the plurality of sub-covers are spaced from each other along an extension path of the signal line.

13. The transmission line assembly according to any one of claims 1 to 12, wherein the signal line further comprises a third end, the third end is located between the first end and the second end, a third opening is provided in the accommodation space, the third end passes through the third opening, and at least one of the first end, the second end, and the third end is configured to be connected to the signal end.

14. The transmission line assembly according to any one of claims 1 to 13, wherein at least two of an end face of the first end, an end face of the second end, and an end face that is of the shielding cover and that is used to be connected to the ground end are coplanar.

15. A printed circuit board assembly, wherein the printed circuit board assembly comprises:
a printed circuit board and the transmission line assembly according to any one of claims 1 to 14, wherein
a signal end and a ground end are disposed on a surface of the printed circuit board; and
the shielding cover is connected to the ground end, and at least one of the first end and the second end is connected to the signal end.

16. The printed circuit board assembly according to claim 15, wherein both the first opening and the second opening face the printed circuit board.

17. The printed circuit board assembly according to claim 15 or 16, wherein a window of the shielding cover faces the printed circuit board.

18. The printed circuit board assembly according to claim 15 or 16, wherein a window of the shielding cover faces away from the printed circuit board.

19. The printed circuit board assembly according to any one of claims 15 to 18, wherein the shielding cover is soldered to the ground end by using a surface mount process.

20. The printed circuit board assembly according to any one of claims 15 to 19, wherein the first end and/or the second end are/is soldered to the signal end by using the surface mount process.

21. An electronic device, wherein the electronic device comprises a housing and the printed circuit board assembly according to any one of claims 15 to 20, and the printed circuit board assembly is located in the housing.
